# EUROPEAN PATENT APPLICATION

(11) **EP 1 755 155 A2**
(43) Date of publication of application: **21.02.2007**
(21) Application number: 06001544.3
(22) Date of filing: 25.01.2006
(51) Int. Cl.: H01L 21/265, B82B 3/00, C30B 11/12

(54) **Semiconductor nanostructures and fabricating the same**

(30) Priority: 15.08.2005 US 203758
(71) Applicant: Agilent Technologies, Inc., Santa Clara, CA 95051 (US)
(72) Inventor: Ranganath, Tirumala R. c/o Agilent Technologies, Palo Alto, CA 94304 (US); Yi, Sungsoo c/o Agilent Technologies, Palo Alto, CA 94304 (US); McAllister, William H. c/o Agilent Technologies, Palo Alto, CA 94304 (US)
(74) Representative: Schoppe, Fritz

(57) **Abstract**

During the growth of semiconductor nanowires (94, 106, 152) on a substrate (12), different respective vapor-liquid-solid reactions that respectively form target segments (98, 116, 124) and sacrificial segments (96, 108, 132) of the semiconductor nanowires (94, 106, 152) at growth locations defined by catalyst particles are supported. The sacrificial segments (96, 108, 132) of the semiconductor nanowires (94, 106, 152) are selectively removed to form semiconductor nanostructures (104, 151, 172) corresponding to the target segments (98, 116, 124) of the semiconductor nanowires (94, 106, 152).

## Description

### BACKGROUND

Nanostructures are structures that have sizes ranging from about 1 nanometer (nm) to about 100 nm. Nanostructures exist in a wide variety of different forms, including nanoparticles, nanorods, and nanowires.

Semiconductor nanostructures with dimensions in the nanometer range have physical and chemical properties that lie between the properties of bulk semiconductor crystals and the properties of semiconductor molecules. For example, in this size region, the semiconductor energy bandgap increases as the nanostructure size decreases. The unique properties of semiconductor nanostructures allow them to be specifically tailored for use in a wide variety of different applications, including fluorescent tagging of biomolecules such as DNA, RNA, proteins, and other types of molecules.

Semiconductor nanoparticles have been fabricated by reacting liquid precursor solutions of the constituent semiconductor elements (e.g., Cd and one of S, Se, and Te) in a solution. Semiconductor nanoparticles and nanorods also have been fabricated by a Solution-Liquid-Solid growth mechanism in which a liquid metal cluster catalyzes the dissolution of reactants to form a supersaturated alloy from which semiconductor nanowires are grown. In this process, the size of the nanowires is controlled by quenching the growth process either by quickly reducing the temperature of the liquid growth solution or quickly changing the composition of the liquid growth solution.

The sizes of the semiconductor nanostructures that are fabricated by the approaches described above cannot be tightly controlled. As a result, the semiconductor nanostructures produced by these fabrication methods exhibit wide size distributions that reduce their effectiveness in many application areas (e.g., fluorescent tagging). Although methods for separating semiconductor nanostructures according to size have been developed, these methods are difficult to implement, increase fabrication costs, and have limited ability to produce monodisperse size distributions.

What is needed is an approach for fabricating semiconductor nanostructures that provides tight control over the size of the semiconductor nanostructures. What also is needed is a semiconductor nanostructure fabrication approach that is capable of flexibly producing semiconductor nanostructures with a wide range of compositions and structural arrangements.

### SUMMARY

In accordance with this invention, during the growth of semiconductor nanowires on a substrate, different respective vapor-liquid-solid reactions that respectively form target segments and sacrificial segments of the semiconductor nanowires at growth locations defined by catalyst particles are supported. The sacrificial segments of the semiconductor nanowires are selectively removed to form semiconductor nanostructures corresponding to the target segments of the semiconductor nanowires.

Other features and advantages of the invention will become apparent from the following description, including the drawings and the claims.

### DESCRIPTION OF DRAWINGS

FIG. 1A is a diagrammatic view of catalyst particles on a substrate in accordance with a prior art vapor-liquid-solid growth mechanism.
FIG. 1B is a diagrammatic view of a vapor-phase semiconductor growth material decomposing into constituent components at the surface of ones of the catalyst particles shown in FIG. 1A.
FIG. 1C is a diagrammatic view of components of the decomposed vapor-phase semiconductor growth material shown in FIG. 1B diffusing through the liquid catalyst particles.
FIG. 1D is a diagrammatic view of the diffusing semiconductor material components shown in FIG. 1C precipitating from a liquid-solid interface formed with the supersaturated liquid catalyst particles.
FIG. 2 is a flow diagram of an embodiment of a method of fabricating semiconductor nanostructures in accordance with the invention.
FIG. 3 is a diagrammatic view of semiconductor nanowires that are grown in accordance with an embodiment of the invention.
FIG. 4 is a diagrammatic view of semiconductor nanostructures that are formed from the semiconductor nanowires shown in FIG. 3 in accordance with an embodiment of the invention.
FIG. 5 is a diagrammatic view of semiconductor nanowires that are grown in accordance with an embodiment of the invention.
FIG. 6A is a diagrammatic view of semiconductor nanowires that are grown in accordance with an embodiment of the invention.
FIG. 6B is a diagrammatic view of semiconductor nanostructures formed from the semiconductor nanowires shown in FIG. 6A in accordance with an embodiment of the invention.
FIG. 7A is a diagrammatic view of semiconductor nanowires that are grown in accordance with an embodiment of the invention.
FIG. 7B is a diagrammatic view of the semiconductor nanowires shown in FIG. 8A after being oxidized in accordance with an embodiment of the invention.
FIG. 7C is a diagrammatic view of a semiconductor nanostructures formed from the oxidized semiconductor nanowires shown in FIG. 7B in accordance with an embodiment of the invention.

### DETAILED DESCRIPTION

In the following description, like reference numbers are used to identify like elements. Furthermore, the drawings are intended to illustrate major features of exemplary embodiments in a diagrammatic manner. The drawings are not intended to depict every feature of actual embodiments nor relative dimensions of the depicted elements, and are not drawn to scale.

### I. INTRODUCTION

The embodiments in accordance with the invention, which are described in detail below, are capable of producing semiconductor nanostructures with tight size control and a wide range of compositions and structures. In accordance with these embodiments, semiconductor nanowires that include target segments and sacrificial segments are formed. Semiconductor nanostructures corresponding to the target segments then are formed by selectively removing the sacrificial segments of the semiconductor nanowires.

As used herein, the terms "nanostructure" and "nanoparticle" refer to compositions of matter that have at least one cross-sectional dimension with a size in a range from 1 nm to 100 nm. The term "nanowire" or "nanorods" refers to a composition of matter that has an average cross-sectional diameter perpendicular to the longitudinal (or growth) axis in a range from 1 nm to 100 nm. The length of a nanowire may range from 1 nm to 1 micrometer (µm) or longer. A nanowire may have any one of wide variety of different cross-sectional shapes perpendicular to the longitudinal axis, including a circular shape, a hexagonal shape, and a rectangular shape.

A "segment" of a nanowire refers to a continuous longitudinal portion of the nanowire. A "target segment" of a nanowire refers to a segment of the nanowire that corresponds to a nanostructure that will be fabricated from the nanowire. A "sacrificial segment" of a nanowire refers to a segment of the nanowire that is consumed or discarded in the process of fabricating nanostructures from the nanowire.

### II. OVERVIEW OF SEMICONDUCTOR NANOWIRE FABRICATION

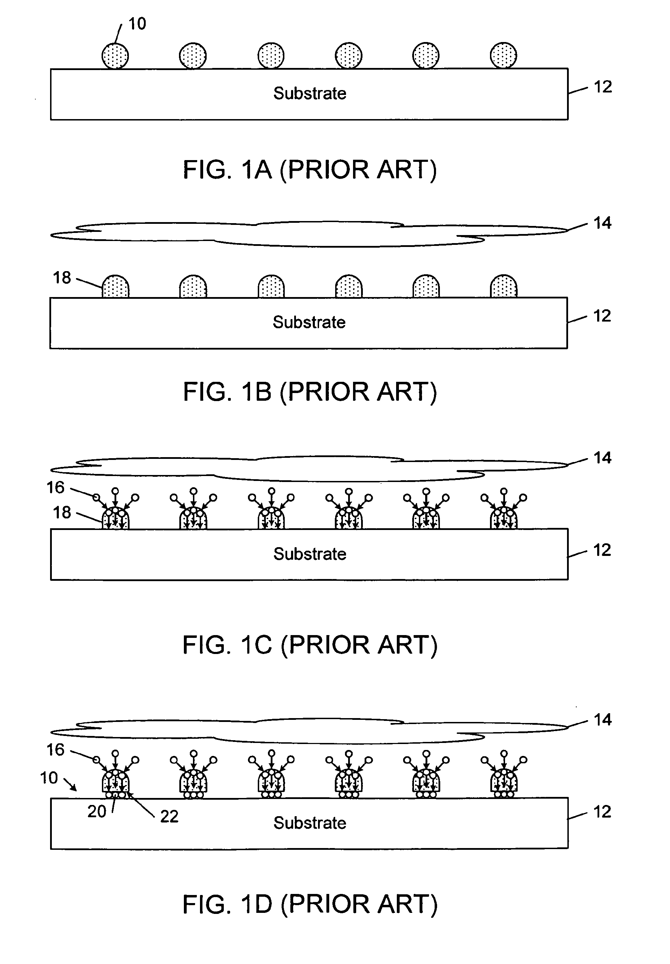

Some of the embodiments in accordance with the invention fabricate semiconductor nanowires by a vapor-liquid-solid growth mechanism that enables the diameters, lengths, and compositions of the target segments of the nanowires to be tightly controlled. The vapor-liquid-solid growth mechanism involves creating with a catalyst a supersaturated liquid-solid interface that drives one-dimensional vapor-phase growth of a semiconductor crystal nanowire. FIGS. 1A-1D show an exemplary process of fabricating nanowires in accordance with the vapor-liquid-solid growth mechanism. These semiconductor nanowires may be fabricated by standard metalorganic chemical vapor deposition (MOCVD) methods.

FIG. 1A shows catalyst particles 10 on a substrate 12. In general, the substrate 12 may be any type of supporting structure, including a semiconductor substrate, a glass substrate, a sapphire substrate, a magnesium oxide substrate, and a ceramic substrate. The substrate 12 may include one or more layers (e.g., semiconducting or insulating layers) on which the catalyst particles 10 are formed. The catalyst particles may be formed of any material that supports the formation of a supersaturated liquid-solid interface that drives one-dimensional vapor-phase growth of a semiconductor crystal nanowire. The selection of the composition of the catalyst particles depends at least in part on the composition of the semiconductor nanostructures that will be fabricated. In some embodiments in accordance with the invention, the catalyst particles are formed of a material selected from Au, Co, Ni, Fe, Al, and alloys thereof. The catalyst particles typically have an average size ranging from 1 nm to 100 nm.

The catalyst particles 10 may be formed on the substrate 12 in any of a wide variety of different ways. For example, the catalyst particles 10 may be formed by laser ablation or by heating a patterned or unpatterned metallic film above the eutectic temperature to produce discrete islands. In some embodiments in accordance with the invention, the catalyst particles 10 nucleate and grow on the surface 12 in the vapor phase. The catalyst particles 10 may be distributed across the surface of the substrate 12 randomly or in accordance with a pattern.

FIG. 1B shows a stage of the vapor-liquid-solid growth process in which the catalyst particles are heated to a temperate above the eutectic temperature and a semiconductor growth material 14 is supplied to the catalyst particles in the vapor phase. In some embodiments in accordance with the invention, the semiconductor growth material includes one or more precursor vapors for forming the constituent semiconductor materials in the nanowires that will be fabricated. Physical methods (e.g., laser ablation and thermal evaporation) and chemical methods (e.g., chemical vapor deposition) may be used to generate the vapor-phase semiconductor growth material 14.

As shown in FIG. 1C, components 16 of the semiconductor growth material 14 decompose at the surface of the catalyst particles 10. At least some of these components 16 diffuse through the catalyst particles 10 forming a eutectic liquid alloy 18.

FIG. 1D shows a stage of the vapor-liquid-solid growth process in which the liquid alloy 18 is supersaturated (e.g., by lowering the growth temperature) and semiconductor material 20 precipitates from liquid-solid interfaces at growth locations 22 defined by the catalyst particles. The precipitating semiconductor material 20 begins the formation of the semiconductor nanowires. The vapor-phase semiconductor growth material 14 maintains the supersaturated state of the liquid alloy 18 and thereby feeds the one-dimensional epitaxial growth of the semiconductor nanowires.

### III. FABRICATING SEMICONDUCTOR NANOSTRUCTURES

### A. OVERVIEW

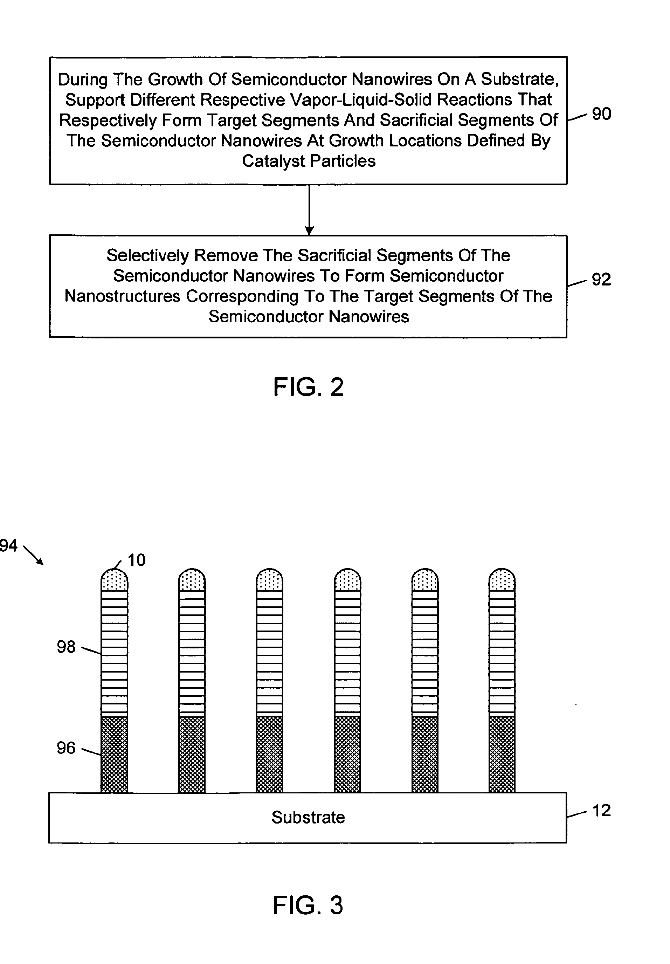

FIG. 2 shows an embodiment for fabricating semiconductor nanostructures in accordance with the invention.

In accordance with this method, during the growth of semiconductor nanowires on a substrate, different respective vapor-liquid-solid reactions that respectively form target segments and sacrificial segments of the semiconductor nanowires are supported at growth locations defined by catalyst particles (block 90).

Each of the nanowires includes one or more target segments and one or more sacrificial segments. In some embodiments in accordance with the invention, at lease one sacrificial segment is located between successive ones of the target segments. The lengths of the various target and sacrificial segments in each of the nanowires may be the same or different. The diameters of the nanowires are determined by the sizes of catalyst particles that are used to grow the nanowires and the lengths of each of the nanowire segments can be precisely controlled by controlling the growth parameters (e.g., nanoparticle catalyst composition, precursor vapor types, precursor vapor flow rates, precursor vapor ratios, temperature, and growth time) during the formation of the nanowire segments.

Each of the target segments and the sacrificial segments is formed of a semiconductor material selected from an elemental semiconductor, a Group IV semiconductor alloy, a Group III-V semiconductor, a Group II-VI semiconductor, and a semiconductor oxide. Each of the target segments and the sacrificial segments may have a uniform longitudinal composition or a varying longitudinal composition. One or more of the target segments and sacrificial segments in each of the nanowires may have different longitudinal regions with different respective semiconductor compositions. The semiconductor compositions at the junctions between these different regions may vary abruptly (e.g., adjacent ones of the regions may form abrupt heterojunctions) or they may vary gradually (e.g., adjacent ones of the regions may form graded junctions).

In some embodiments in accordance with the invention, the target and sacrificial segments of each of the nanowires are formed of materials selected from the same semiconductor material family. As used herein, the term "semiconductor material family" refers to a group of semiconductor materials that are composed of, for example, two or more members of a discrete set of elemental atoms (e.g., a set of Group III elemental atoms and Group V elemental atoms) that are capable of forming an epitaxial nanowire segment on a compatible adjacent nanowire segment. In some embodiments in accordance with the invention, each of the semiconductor nanowires includes at least one of the following types of adjacent segments: an InₓGa₁₋ₓAs_{y}P_{1-y} segment adjacent to an InP segment, where 0≤x≤1 and 0≤y≤1; an AlₓGa_{y}In_{1-x-y}As segment adjacent to an InP segment, where 0≤x≤1 and 0≤y≤1; an adjacent to a GaAs segment, where InₓGa₁₋ₓAs segment 0≤x≤1; and an AlₓGa₁₋ₓAs segment adjacent to a GaAs segment, where 0≤x≤1.

The sacrificial segments of the semiconductor nanowires are selectively removed to form semiconductor nanostructures corresponding to the target segments of the semiconductor nanowires (block 92). The sacrificial segments may be selectively removed in a variety of different ways. In some embodiments in accordance with the invention, the sacrificial segments have chemical, optical, or physical properties that are sufficiently different from the corresponding properties of the target segments that allow the sacrificial segments to be selectively separated from the target segments.

In some embodiments in accordance with the invention, the sacrificial segments are selectively etchable with respect to the target segments. In these embodiments, the sacrificial segments may be removed by an etchant that selectively consumes the sacrificial segments while leaving the target segments substantially unchanged. The selectivity of an etch process applied to two different materials may be measured by the ratio of the etch rates of the different materials. In some embodiments in accordance with the invention, the etch rate of the sacrificial segments relative to the target segments is at least 10:1. During the selective etching process, the etchant may be in a liquid phase or a vapor phase.

During or after the process of selectively removing the sacrificial nanowire segments, the remaining semiconductor nanostructures may be passivated. In some embodiments in accordance with the invention, the semiconductor nanostructures are passivated by coating them with one or more organic compounds, such as tri-n-octyl phosphine (TOP) and tri-n-octyl phosphine oxide (TOPO). A population of discrete unconnected nanorods that are formed in accordance with the invention may be stored in the form of, for example, a suspension or dispersion. The unconnected nanorods typically have an average diameter ranging from 1 nm to 100 nm and an average length ranging from 1 nm to 100 nm.

The passivated nanostructures may be incorporated within a wide variety of different apparatus or systems. For example, the nanostructures may be dispersed within a plastic film that is incorporated within a fluorescent tagging device.

### B. EXEMPLARY EMBODIMENTS IN ACCORDANCE WITH THE INVENTION

Exemplary embodiments in accordance with the invention of the nanostructure fabrication method shown in FIG. 2 are described in detail below.

### EXAMPLE 1

FIG. 3 shows nanowires 94 that are formed on the substrate 12 under respective ones of the catalyst particles 10 in accordance with an embodiment of the method shown in FIG. 2. Each of the nanowires 94 includes a first segment 96 that is formed of a first semiconductor material and a second segment 98 that is formed of a second semiconductor material different from the first semiconductor material. The longitudinal length of the first segments 96 is different from the longitudinal length of the second segments 98. At least one of the first and second segments 96, 98 of each nanowire 94 is selectively etchable with respect to the other segment.

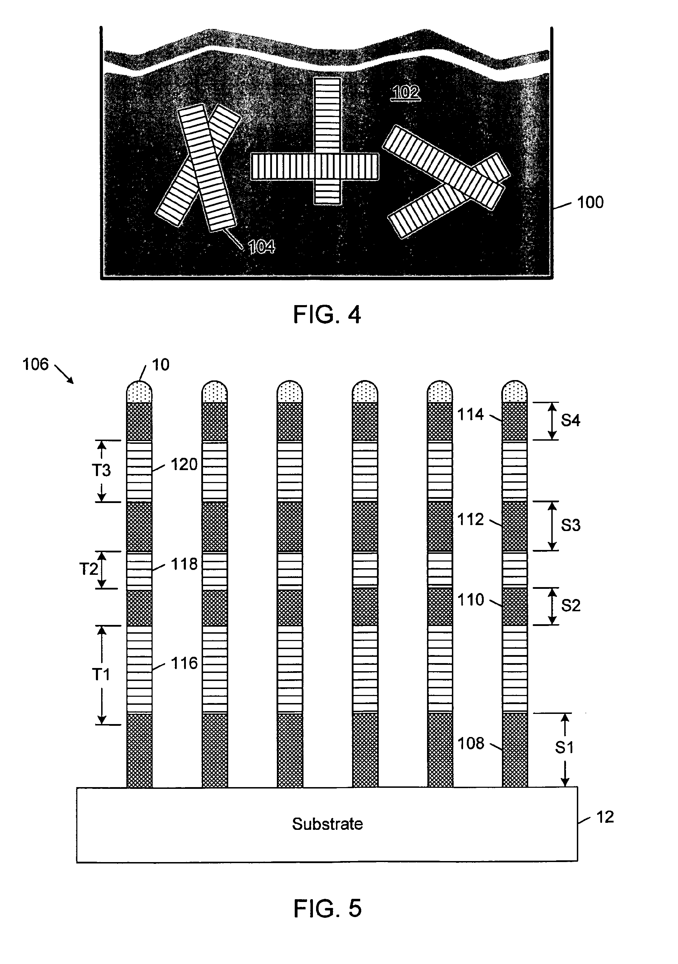

FIG. 4 shows a diagrammatic view of a container 100 holding a liquid etchant 102 that selectively removes the sacrificial segments 96 to form semiconductor nanostructures 104 corresponding to the target segments 98 of the nanowires 94. The semiconductor nanostructures 104 form a population of discrete nanorods having an average diameter ranging from 1 nm to 100 nm and an average length ranging from 1 nm to 100 nm, where each of the nanorods has a uniform longitudinal semiconductor composition.

In some embodiments in accordance with the invention, the first segments 96 are formed of InP and the second segments 98 are formed of InₓGa₁₋ₓAs, where 0≤x≤1. In other embodiments in accordance with the invention, the second segments 98 are formed of InP and the first segments 96 are formed of InₓGa₁₋ₓAs, where 0≤x≤1. In one exemplary method of fabricating these embodiments in accordance with the invention, the nanowires 94 may be formed at growth locations defined by gold nanoparticles 10 on a silicon oxide layer formed on a silicon wafer 12, which is loaded into a CVD chamber of a fabrication system in some embodiments in accordance with the invention.

The InP segments are formed by supplying into the CVD chamber a precursor vapor that includes an organometallic compound of indium and a precursor vapor of phosphine. Indium in the vapor-phase indium-containing organometallic compound decomposes and diffuses into the gold nanoparticles to form a liquefied gold-indium alloy at each growth location. After the liquefied alloys have become saturated, indium precipitates from the liquid-solid interfaces at the bottoms of the liquefied alloys. The precipitating indium reacts with the phosphine vapor to form InP at the liquid-solid interfaces. The growth parameters (e.g., nanoparticle catalyst composition, precursor vapor types, precursor vapor flow rates, precursor vapor ratios, temperature, and growth time) are selected to fabricate InP nanowire segments of a specified longitudinal length.

The InₓGa₁₋ₓAs segments are formed by supplying into the CVD chamber a precursor vapor that includes an organometallic compound of indium, a precursor vapor that includes an organometallic compound of gallium, and a precursor vapor of arsine. Indium in the vapor-phase indium-containing organometallic and gallium in the vapor-phase gallium-containing organometallic compound decompose and diffuse into the gold nanoparticles to form a liquefied gold-indium-gallium alloy at each growth location. After the liquefied alloys have become saturated, indium and gallium precipitate from the liquid-solid interfaces at the bottoms of the liquefied alloys. The precipitating indium and gallium react with the arsine vapor to form InₓGa₁₋ₓAs at the liquid-solid interfaces. The growth parameters (e.g., nanoparticle catalyst composition, precursor vapor types, precursor vapor flow rates, precursor vapor ratios, temperature, and growth time) are selected to fabricate InₓGa₁₋ₓAs nanowire segments of a specified longitudinal length.

In some embodiments in accordance with the invention, the InP segments are the designated target segments and the InₓGa₁₋ₓAs segments are the designated sacrificial segments. In these embodiments, the InₓGa₁₋ₓAs sacrificial segments may be removed selectively by etching in an aqueous solution that includes sulfuric acid and hydrogen peroxide (e.g., a solution of sulfuric acid : hydrogen peroxide : DI-water in a volume ratio of 1:1:50). This etching process will remove all of the sacrificial InₓGa₁₋ₓAs segments and leave the remaining InP nanostructures in the etching solution.

In other embodiments in accordance with the invention, the InₓGa₁₋ₓAs segments are the target segments and the InP segments are the sacrificial segments. In these embodiments, the InP sacrificial segments may be removed selectively by etching in an aqueous solution that includes hydrochloric acid (e.g., a solution of hydrochloric acid : DI-water in a volume ratio of 2:3). This etching process will remove all of the sacrificial InP segments and leave the remaining InₓGa₁₋ₓAs nanostructures in the etching solution.

### EXAMPLE 2

FIG. 5 shows nanowires 106 that are formed on the substrate 12 under respective ones of the catalyst particles 10 in accordance with an embodiment of the method shown in FIG. 2. Each of the nanowires 106 includes a set of first segments 108, 110, 112, 114 that are formed of a first semiconductor material and a set of second segments 116, 118, 120 that are formed of a second semiconductor material different from the first semiconductor material. The first segments 108-114 have different respective longitudinal lengths S1, S2, S3, S4, and the second segments 116-120 have different respective longitudinal lengths T1, T2, T3. In other embodiments in accordance with the invention, one or more pairs of the first and second segments 108-120 may have the same longitudinal lengths.

In some embodiments in accordance with the invention, the first segments 108-114 are selectively etchable with respect to the second segments 116-120 or the second segments 116-120 are selectively etchable with respect to the first segments 108-114 or the first segments 108-114 and the second segments 116-120 are selectively etchable with respect to each other.

In some embodiments in accordance with the invention, the first segments 108-114 are formed of InP and the second segments 116-120 are formed of InₓGa₁₋ₓAs, where 0≤x≤1. In other embodiments in accordance with the invention, the second segments 116-120 are formed of InP and the first segments 108-114 are formed of InₓGa₁₋ₓAs, where 0≤x≤1. The InP and InₓGa₁₋ₓAs segments may be formed in accordance with the process described above in connection with EXAMPLE 1. The vapor-phase growth material for forming the InP segments and the vapor-phase growth material for forming the InₓGa₁₋ₓAs segments are alternately supplied to the CVD chamber to form the nanowires 106.

If the InₓGa₁₋ₓAs segments are the designated target segments, the InP sacrificial segments may be removed by selective etching in an aqueous solution that includes sulfuric acid and hydrogen peroxide (e.g., a solution of sulfuric acid : hydrogen peroxide : DI-water in a volume ratio of 1:1:50). If the InP segments are the designated target segments, the InₓGa₁₋ₓAs sacrificial segments may be removed by selective etching in an aqueous solution that includes hydrochloric acid (e.g., a solution of hydrochloric acid : DI-water in a volume ratio of 2:3).

### EXAMPLE 3

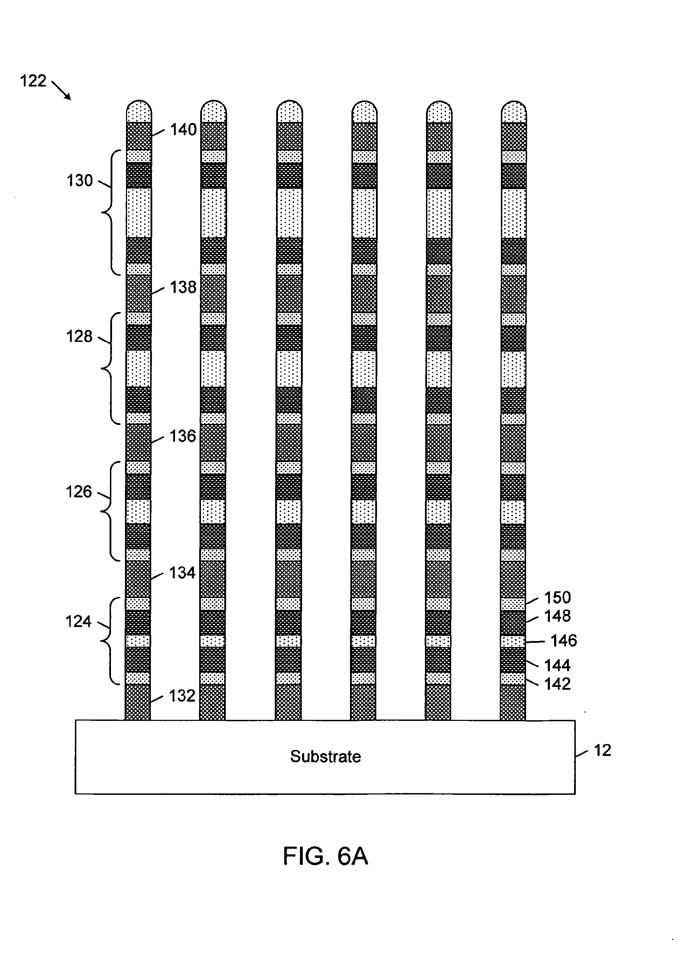

FIG. 6A shows nanowires 122 that are formed on the substrate 12 under respective ones of the catalyst particles 10 in accordance with an embodiment of the method shown in FIG. 2. Each of the nanowires 122 includes a set of successive target segments 124, 126, 128, 130 that are separated by respective ones of a set of sacrificial segments 132, 134, 136, 138, 140. In FIG. 6A, the target segments 124-130 have different respective longitudinal lengths, whereas the sacrificial segments 132-140 have the same longitudinal lengths. In other embodiments in accordance with the invention, one or more pairs of the target segments 124-130 may have the same longitudinal lengths and one or more pairs of the sacrificial segments 132-140 may have different longitudinal lengths.

Each of the target segments 124-130 has a varying longitudinal composition. In particular, each of the target segments 124-130 includes a set of successive longitudinal sub-regions 142, 144, 146, 148, 150, where adjacent ones of these sub-regions 142-150 have different respective semiconductor compositions. In some embodiments in accordance with the invention, each of the sub-regions 142-150 is formed of a material within the same semiconductor family (e.g., InₓGa₁₋ₓAs_{y}P_{1-y}, where 0≤x≤1 and 0≤y≤1; AlₓGa_{y}In_{1-x-y}As, where 0≤x≤1 and 0≤y≤1; InₓGa₁₋ₓAs, where 0≤x≤1; and AlₓGa₁₋ₓAs, where 0≤x≤1), where the alloy compositions vary either abruptly or gradually with longitudinal position along the target segments 124-130. In other embodiments in accordance with the invention, at least two of the sub-regions 142-150 are formed of respective semiconductor materials from different semiconductor families.

In some embodiments in accordance with the invention, the compositions and structural arrangements of the sub-regions of each of the target segments 124-130 are configured to produce heterostructures selected from a wide variety of different semiconductor heterostructures, including single and multiple quantum well heterostructures. For example, in one embodiment of the invention shown in FIG. 6A, the sub-region 146 is a quantum well sub-region formed of a first semiconductor material and the two sub-regions 144, 148 are quantum barrier sub-regions formed of a second semiconductor material having a wider energy bandgap than the first semiconductor material. The sub-regions 142, 150 may correspond to cladding sub-regions, which have a lower refractive index than the quantum well sub-region 146.

The sacrificial segments 132-140 are selectively etchable with respect to the constituent components of the target segments 124-130. In one exemplary embodiment in accordance with the invention, each of the sacrificial segments 132-140 is formed of InP, the sub-regions 142 and 150 of each of the target segments 124-130 are formed of Inₓ₁Ga₁₋ₓ₁As, the sub-regions 144, 148 of each of the target segments 124-130 are formed of Inₓ₂Ga₁₋ₓ₂As, and the sub-region 146 of each of the target segments 124-130 is formed of Inₓ₃Ga₁₋ₓ₃As, where 0 ≤ x1 ≠ x2 ≠ x3 ≤ 1. The InP and InₓGa₁₋ₓAs segments may be formed in accordance with the process described above in connection with EXAMPLE 1.

The InP sacrificial segments 132-140 may be removed by selective etching in an aqueous solution that includes sulfuric acid and hydrogen peroxide (e.g., a solution of sulfuric acid : hydrogen peroxide : DI-water in a volume ratio of 1:1:50).

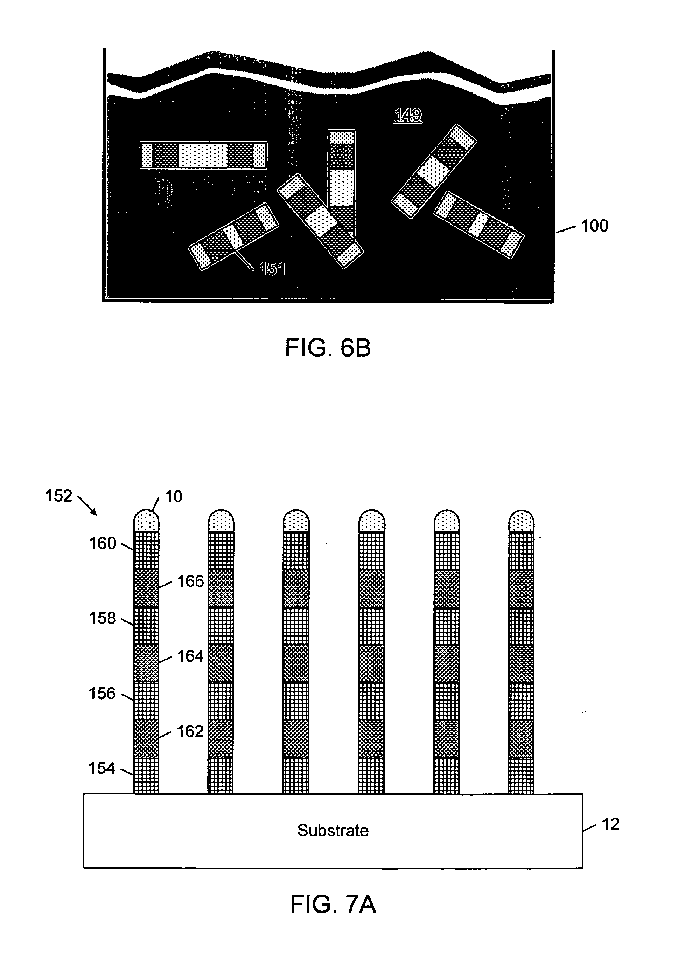

FIG. 6B shows a diagrammatic view of the container 100 holding a liquid etchant 149 that selectively removes the InP sacrificial segments 132-140 to form semiconductor nanostructures 151 corresponding to the target segments 124-130 of the nanowires 122. The semiconductor nanostructures 151 form a population of discrete nanorods having an average diameter ranging from 1 nm to 100 nm and an average length ranging from 1 nm to 100 nm, where each of the nanorods has a varying longitudinal semiconductor composition.

### EXAMPLE 4

FIG. 7A shows nanowires 152 that are formed on the substrate 12 under respective ones of the catalyst particles 10 in accordance with an embodiment of the method shown in FIG. 2. Each of the nanowires 152 includes a set of first segments 154, 156, 158, 160 that are formed of a first semiconductor material and a set of second segments 162, 164, 166 that are formed of a second semiconductor material different from the first semiconductor material. The first segments 154-160 may have the same or different respective longitudinal lengths. Similarly, the second segments 162-166 may have the same or different respective longitudinal lengths.

At least one of the first and second semiconductor materials is capable of reacting with an atomic or molecular reactant species to form a compound semiconductor material that is different from the constituent material of the first and second semiconductor materials. For example, the first and second semiconductor materials may be Group IV semiconductors that are capable of reacting with, for example, an oxygen-containing species to form a semiconductor oxide and a nitride-containing species to form a semiconductor nitride.

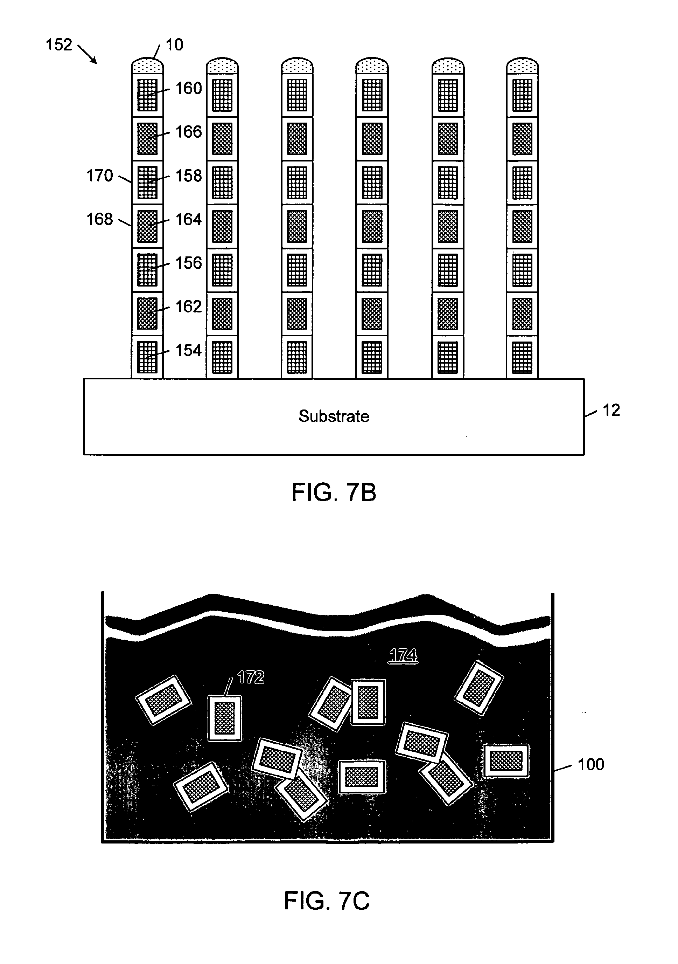

As shown in FIG. 7B, in some embodiments in accordance with the invention, the first and second semiconductor materials are reacted with one or more reactant species to form compound semiconductor shells 168, 170 that respectively encapsulate the first and second semiconductor materials of the first and second segments (e.g., first and second segments 158, 164). In some of these embodiments in accordance with the invention, one or both of the compound semiconductor shells 168, 170 are selectively etchable with respect to the other. The different etchability properties of the compound semiconductor shells 168, 170 may be exploited to selectively remove the designated sacrificial nanowire segments to form the desired semiconductor nanostructures 172 by immersing the nanowires 152 in a selective etchant 174, as shown in FIG. 7C.

In one exemplary embodiment in accordance with the invention, one of the first and second semiconductor materials is silicon and the other one of the first and second semiconductor materials is germanium. In this embodiment, the silicon and germanium nanowire segments are oxidized to form silicon oxide (e.g., SiO₂) and germanium oxide (e.g., GeO₂), respectively. If the encapsulated silicon nanowire segments are the designated target segments, the sacrificial germanium segments may be removed by selective etching in an aqueous solution that includes ammonium hydroxide (i.e., NH₄OH), which etches germanium oxide at a significantly higher rate than silicon oxide. If the encapsulated germanium nanowire segments are the designated target segments, the sacrificial silicon segments may be removed by selective etching in an aqueous solution that includes hydrofluoric acid (i.e., HF), which etches silicon oxide at a significantly higher rate than germanium oxide.

### IV. CONCLUSION

The exemplary embodiments in accordance with the invention, which are described in detail above, are capable of producing semiconductor nanostructures with tight size control and a wide range of compositions and structures. In the embodiments in accordance with the invention, semiconductor nanowires that include target segments and sacrificial segments are formed. Semiconductor nanostructures corresponding to the target segments then are formed by selectively removing the sacrificial segments of the semiconductor nanowires.

Other embodiments in accordance with the invention are within the scope of the claims.

## Claims

1. Semiconductor nanostructures (104, 151, 172) fabricated by a process comprising:
during the growth of semiconductor nanowires (94, 106, 152) on a substrate (12), supporting different respective vapor-liquid-solid reactions that respectively form target segments (98, 116, 124) and sacrificial segments (96, 108, 132) of the semiconductor nanowires (94, 106, 152) at growth locations defined by catalyst particles (10); and
selectively removing the sacrificial segments (96, 108, 132) of the semiconductor nanowires (94, 106, 152) to form semiconductor nanostructures (104, 151, 172) corresponding to the target segments (98, 116, 124) of the semiconductor nanowires (94, 106, 152).

2. The semiconductor nanostructures of claim 1, wherein the supporting comprises:
supplying a first vapor-phase semiconductor growth material that supersaturates liquid-solid interfaces at the growth locations and precipitates the target segments (98, 116, 124) of the semiconductor nanowires (94, 106, 152); and
supplying a second vapor-phase semiconductor growth material that supersaturates liquid-solid interfaces at the growth locations and precipitates the sacrificial segments (96, 108, 132) of the semiconductor nanowires (94, 106, 152).

3. The semiconductor nanostructures of claim 2, wherein the process further comprises varying growth parameters for the semiconductor nanowires (94, 106, 152) while supplying the first vapor-phase semiconductor growth material to form target nanowires segments (98, 116, 124) having varying longitudinal compositions.

4. The semiconductor nanostructures of claim 3, wherein the varying comprises supplying the first vapor-phase semiconductor growth material with the growth parameters selected to form target nanowires segments (98, 116, 124) comprising a semiconductor alloy of at least three constituent semiconductor elements and having an alloy composition that is different at different respective positions along the target nanowires segments (98, 116, 124).

5. The semiconductor nanostructures of claim 1, wherein the process further comprises oxidizing at least one of the target segments (98, 116, 124) and the sacrificial segments (96, 108, 132) of the semiconductor nanowires (94, 106, 152).

6. A method of fabricating semiconductor nanostructures (104, 151, 172), comprising:
during the growth of semiconductor nanowires (94, 106, 152) on a substrate (12), supporting different respective vapor-liquid-solid reactions that respectively form target segments (98, 116, 124) and sacrificial segments (96, 108, 132) of the semiconductor nanowires (94, 106, 152) at growth locations defined by catalyst particles; and
selectively removing the sacrificial segments (96, 108, 132) of the semiconductor nanowires (94, 106, 152) to form semiconductor nanostructures (104, 151, 172) corresponding to the target segments (98, 116, 124) of the semiconductor nanowires (94, 106, 152).

7. A system, comprising:
a population of discrete unconnected nanorods (104, 151, 172) having an average diameter ranging from 1 nm to 100 nm and an average length ranging from 1 nm to 100 nm, each of the nanorods (104, 151, 172) having a varying longitudinal semiconductor composition.

8. The system of claim 7, wherein each of the nanorods (104, 151, 172) comprises a heterojunction formed between two different constituent semiconductor materials.

9. The system of claim 7, wherein each of the nanorods (104, 151, 172) includes at least one of the following types of adjacent segments: an InₓGa₁₋ₓAs_{y}P_{1-y} segment adjacent to an InP segment, where 0≤x≤1 and 0≤y≤1; an AlₓGa_{y}In_{1-x-y}As segment adjacent to an InP segment, where 0≤x≤1 and 0≤y≤1; an InₓGa₁₋ₓAs segment adjacent to a GaAs segment, where 0≤x≤1; and an AlₓGa₁₋ₓAs segment adjacent to a GaAs segment, where 0≤x≤1.

10. The system of claim 7, wherein each of the nanorods (104, 151, 172) comprises a first semiconductor material encapsulated in a second semiconductor material.
